(19) Europäisches Patentamt

European Patent Office

Office européen des brevets

(11) EP 0 577 469 B1

## (12) FASCICULE DE BREVET EUROPEEN

(45) Date de publication et mention
de la délivrance du brevet:
**22.12.1999 Bulletin 1999/51**

(51) Int Cl.⁶: $G01R\ 33/09$, $H01F\ 1/24$

(21) Numéro de dépôt: **93401587.6**

(22) Date de dépôt: **22.06.1993**

(54) **Transducteur magnétorésistif**

Magnetoresistiver Wandler

Magnetoresistive transducer

(84) Etats contractants désignés:
**DE FR GB IT NL**

(30) Priorité: **23.06.1992 FR 9207626**

(43) Date de publication de la demande:
**05.01.1994 Bulletin 1994/01**

(73) Titulaire: **THOMSON-CSF**
**75008 Paris (FR)**

(72) Inventeurs:
• **Valet, Thierry**
**F-92402 Courbevoie Cedex (FR)**
• **Tyc, Stéphane**
**F-92402 Courbevoie Cedex (FR)**

(74) Mandataire: **Guérin, Michel et al**
**Thomson-CSF Propriété Intellectuelle,**
**13, Avenue du Président Salvador Allende**
**94117 Arcueil Cédex (FR)**

(56) Documents cités:
EP-A- 0 216 062        EP-A- 0 301 902
US-A- 3 840 898        US-A- 5 043 693

• SOLID STATE COMMUNICATIONS vol. 9, 1971,
pages 1197 - 1200 Y. GOLDSTEIN ET AL.
'Ferromagnetism in granular nickel films'
• PATENT ABSTRACTS OF JAPAN vol. 014, no.
194 (E-919)20 Avril 1990 & JP-A-2 040 972
( TATSUMI TOMIHIKO ) 9 Février 1990
• PATENT ABSTRACTS OF JAPAN vol. 011, no.
081 (E-488)12 Mars 1987 & JP-A-61 234 083
( HITACHI LTD. ) 18 Octobre 1986
• IBM TECHNICAL DISCLOSURE BULLETIN. vol.
7, no. 6, Novembre 1964, NEW YORK US page
427 J.C. SUITS 'High Magnetic Field Measuring
Devices'

## Description

L'invention concerne une tête de lecture magnétique et notamment une tête de lecture magnétique en couches minces utilisable pour la détection de champs magnétiques.

Dans les différents domaines d'applications des matériaux magnétorésistifs en couches minces (têtes de lecture pour l'enregistrement magnétique, magnétomètres, compas, divers types de capteurs), la totalité des composants est aujourd'hui réalisée avec des couches minces d'alliages magnétiques tels que le "Permalloy" : $Ni_{80}Fe_{20}$.

Le phénomène physique exploité est la magnétorésistance anisotrope, qui se traduit par une résistivité ayant pour expression :

$$\rho = \rho_0 \, (1 + \delta \cos^2 \theta) \tag{1}$$

où $\theta$ est l'angle entre l'aimantation et le courant dans le matériau, et $\delta$ la variation relative de résistivité entre les deux situations extrêmes : aimantation parallèle ou perpendiculaire au courant (typiquement $\delta$ - 0.01).

De telles couches minces présentent un certain nombre d'inconvénients qui limitent les performances des composants. On citera principalement :

- une résistivité liée à l'orientation de l'aimantation, grandeur dont la relation à celle que l'on souhaite mesurer (l'amplitude et/ou l'orientation d'un champ magnétique extérieur) est définie par une loi de comportement souvent complexe (non linéaire) voire même non univaluée (hystérésis).
- l'existence d'un bruit intrinsèquement lié au caractère discontinu et non déterministe du processus d'aimantation d'un ferromagnétique : bruit de Barkausen.
- le fait que la référence d'orientation du champ magnétique est relative au courant, ce qui est une contrainte de mise en oeuvre.
- une importante dépendance en température de la résistivité moyenne et de la magnétorésistance $\delta$ (typiquement 1000 ppm/°C) de ce type d'alliage au voisinage de la température ambiante.
- une résistivité moyenne faible, de l'ordre de quelques dizaines de $\mu\Omega.cm$ impliquant des géométries de transducteurs complexes (serpentins) afin d'atteindre des valeurs de résistance aisées à mesurer. De plus, cela exclut la réalisation de capteurs où le courant circulerait perpendiculairement au plan de la couche mince. Or cette possibilité peut se révéler très intéressante du point de vue de l'intégration, en particulier dans le domaine de l'enregistrement magnétique tel que cela est décrit dans la Demande de Brevet français n° 90 09301.

On connaît également des dispositifs utilisant des multicouches métalliques magnétiques, présentant des effets plus importants : $\delta \sim 0.1$ (à température ambiante, et pour les mêmes valeurs de champ de saturation) ; indépendamment de l'orientation relative des aimantations au courant, mais sans que cela ne remédie aux autres insuffisances citées. Notamment en ce qui concerne la dépendance en température et la faible valeur de la résistivité moyenne.

Il a été observé par ailleurs que la conductance d'une jonction tunnel métal/isolant/métal dont les deux électrodes sont constituées de ferromagnétiques itinérants, itinérants signifiant que les électrons porteurs du mouvement magnétique participent à la conduction électrique (typiquement métaux 3d magnétiques et leurs alliages) dépend de l'orientation relative des vecteurs d'aimantation de part et d'autre de la barrière. Plus précisément, si $\theta$ est l'angle entre ces deux vecteurs et d la largeur de barrière, on a une conductance :

$$G = G_0 \, e - \frac{d}{\lambda} \, (1 + \Delta \cos^2 \frac{\theta}{2}) \tag{2}$$

où $\lambda$ est une longueur tunnel dépendant des matériaux, typiquement 1 nm$\leq \lambda \leq$ 100nm, et $\Delta$ une amplitude de modulation soit comprise entre 0 et 1.

On trouvera dans le document de T. MIYAZAKI et al, J.M.M.M. 98, L7 (1991) une compilation des valeurs de $\Delta$ observées à ce jour, d'où l'on déduit un effet maximum $\Delta = 0.14$ à température ambiante pour une jonction $Ni_{82}Fe_{18}/Al_2O_3/Co$.

Il est d'autre part bien établi que par des méthodes de coévaporation ou de copulvérisation il est possible de réaliser des couches minces constituées d'une dispersion de fines particules métalliques magnétiques dans diverses matrices isolantes ($Al_2O_3, SiO_2, BN...$). Pour des fractions volumiques de phase métallique inférieure à 50 %, dans le cas où les phases métalliques et isolantes sont non miscibles, et si l'on dépose de tels matériaux sur un substrat non chauffé, on obtient généralement des particules quasi-sphériques de quelques dizaines d'Angstroems de diamètre complètement isolées les unes des autres par la matrice isolante qui peut être amorphe ($SiO_2$, $Al_2O_3$) ou cristallisée (BN). Dans ces conditions, et ceci a été démontré expérimentalement pour le système $Ni/SiO_2$ dans le document J.I. GITTLEMAN et al, Phys. Rev. B5 (9), 3609 (1972), le système peut présenter simultanément un comportement superparamagnétique et une conductivité électrique en champ faible dominée par l'effet tunnel entre les particules.

La notion de superparamagnétisme désigne le fait que chaque particule magnétique se comporte comme un moment magnétique classique de valeur $VM_S$ (V est le volume de la particule et $M_S$ l'aimantation du matériau magnétique constitutif), dont l'orientation fluctue thermiquement avec un temps caractéristique :

$$\tau = \tau_o \, e_k \frac{E_b}{kT} \qquad\qquad (3)$$

où $t_0$ est une constante peu dépendante du matériau, de l'ordre de 10-10 s, et $E_b$ une énergie d'activation liée aux différentes anisotropies magnétiques de la particule. Pour une particule à anisotropie uniaxiale :

$$E_b = K_u V \qquad\qquad (4)$$

où $K_u$ est la constante d'anisotropie. On notera que la proportionnalité de $E_b$ au volume de la particule dépasse le cas particulier d'une énergie d'activation associée à une anisotropie.

Le document US 5 043 693 décrit une couche magnétorésistive réalisée avec des éléments magnétiques répartis au sein d'une couche en matériau non magnétique.

L'invention tire profit des propriétés de telles couches minces composites pour permettre la réalisation de têtes de lecture magnétiques.

L'invention concerne donc une tête de lecture magnétique caractérisée en ce qu'elle comporte :

- une couche d'un matériau composite comportant des particules de matériau magnétique noyées dans un matériau non magnétique et isolant ou semiconducteur ;
- deux pôles magnétiques séparés par un entrefer et situés sur une première face de la couche de matériau composite ;
- un premier conducteur situé sur la première face de la couche de matériau composite entre cette face et les deux pôles magnétiques ;
- un deuxième conducteur situé sur une deuxième face de la couche de matériau composite opposée à la première face.

Les différents objets et caractéristiques de l'invention apparaîtront plus clairement dans la description qui va suivre et dans les figures annexées qui représentent :

- les figures 1a, 1b et 2, des exemples de base du transducteur ;
- la figure 3, une courbe de fonctionnement du transducteur des figures 1 et 2 ;
- les figures 4 et 5, des transducteurs équipés de moyens pour appliquer un champ magnétique continu ;
- la figure 6, un dispositif dans lequel certaines particules sont plus grosses que d'autres ;
- la figure 7, un dispositif possédant des particules de formes différentes ;
- la figure 8, un dispositif dans lequel des particules de type différent sont réparties par couches ;
- la figure 9, un exemple de réalisation d'une tête magnétique appliquant le transducteur ;
- la figure 10, un exemple de réalisation d'une tête magnétique en couches minces ;
- la figure 11, une tête magnétique planaire selon l'invention.

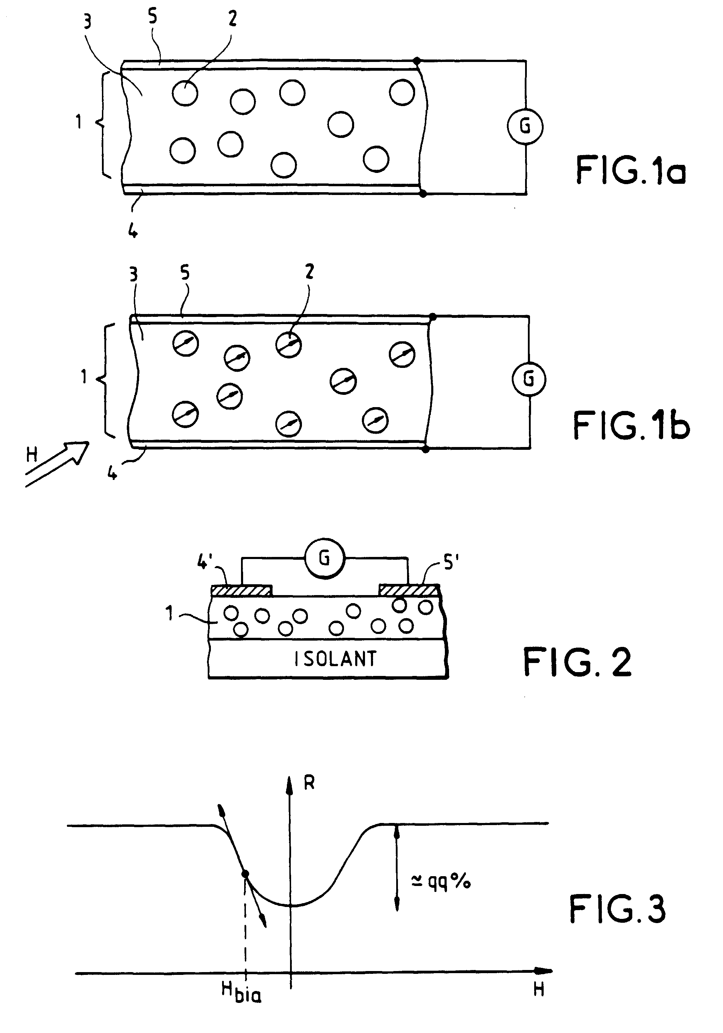

Le dispositif de base de la figure 1a comporte une couche 1 d'un matériau composite constitué de particules 2 en matériau magnétique noyée dans un matériau isolant ou semiconducteur 3. Cette couche 1 est enserrée entre deux électrodes 4 et 5. Un dispositif de mesure de résistance est connecté aux électrodes 4 et 5.

Sous l'effet d'un champ magnétique H extérieur à détecter, l'orientation de l'aimantation dans les particules 2 prend la direction du champ magnétique H. L'orientation des aimantations dans les différentes particules va donc être uniforme comme cela est représenté en figure 1b.

Plus précisément, l'assemblée des particules constituant un élément macroscopique de la couche mince composite suivra alors sous l'effet d'un champ magnétique extérieur une loi d'aimantation de Langevin. Ce comportement parfaitement réversible (la loi de Langevin est anhystérétique), est observé tant que le champ magnétique appliqué varie à une échelle de temps grande devant $\tau$, permettant au système de se thermaliser. Si de plus la conductance tunnel entre particules suit la loi (2), il est clair qu'un champ magnétique extérieur, par l'introduction d'une orientation globale des moments magnétiques contrastant avec la configuration aléatoire et fluctuante en champ nul, va provoquer une diminution de la résistivité macroscopique du matériau.

Dans ces conditions, l'appareil de mesure de résistance G connecté aux électrodes 4 et 5 permet de détecter la variation de résistivité de la couche 1 et donc de détecter le champ magnétique H.

Le dispositif des figures 1a, 1b possède des électrodes situées de part et d'autre de la couche 1 et permettant de mesurer la résistivité de la couche 1 perpendiculairement à son plan.

Comme cela est représenté en figure 2, les deux électrodes 4' et 5' peuvent être situées sur une même face de la couche 1. Elles permettent alors de mesurer la résistivité de la couche perpendiculairement à son plan.

La variation de résistivité en fonction du champ magnétique suit la loi de variation représentée en figure 3. On prévoit donc de pouvoir fonctionner dans une zone de variation linéaire fournissant une bonne sensibilité de détection. Pour cela on applique un champ magnétique continu, par exemple $H_{bias}$ sur la figure 3, ce qui permet de fonctionner dans une zone linéaire de la courbe.

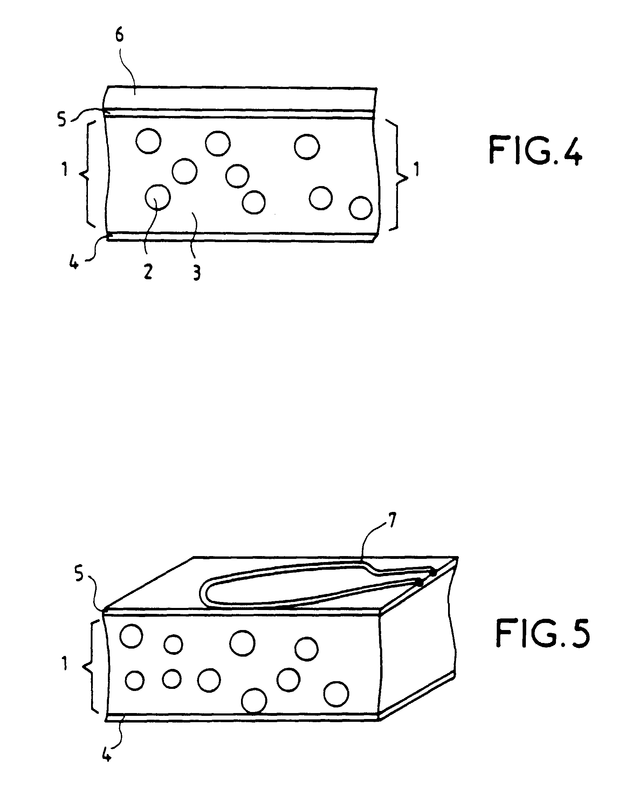

Les moyens permettant d'appliquer ce champ magnétique continu pourront être un aimant permanent tel qu'une couche d'un matériau aimanté 6 représentée sur la figure 4. Cette couche 6 peut être une couche mince ou épaisse selon l'intensité d'aimantation induite et selon l'épaisseur de la couche 1.

On peut également prévoir une boucle 7 conductrice de l'électricité permettant d'induire un champ magnétique dans la couche 1.

Selon une variante de réalisation on prévoit un matériau composite composé de plusieurs types de particules immergées dans une matrice isolante. La répartition de ces particules peut être uniforme ou varier d'un point à l'autre.

Les types de particules peuvent être différents en raison de la composition du matériau qui les compose.

Par exemple, on peut choisir au moins un type de grain à comportement magnétique "dur", (c'est-à-dire insensibles aux champs que l'on souhaite détecter), et au moins un autre type de grain à comportement magnétique "doux", c'est-à-dire tels que leur aimantation s'aligne facilement sous l'effet des champs que l'on souhaite détecter, et à temps de relaxation suffisamment petit au regard de l'application. On prévoit en moyenne qu'un grain doux n'a que des premiers voisins durs et réciproquement, de telle manière que les jonctions tunnels doux/doux ou dur/dur ne percolent pas à travers le matériau.

Dans un tel matériau, les grains durs ont leurs magnétisations dirigées dans une direction définie par exemple par une saturation préalable. Ceci permet de retrouver une modulation relative de résistivité égale à $\Delta$ et non plus $\Delta/2'$, et une résistance fonction impaire du champ appliqué.

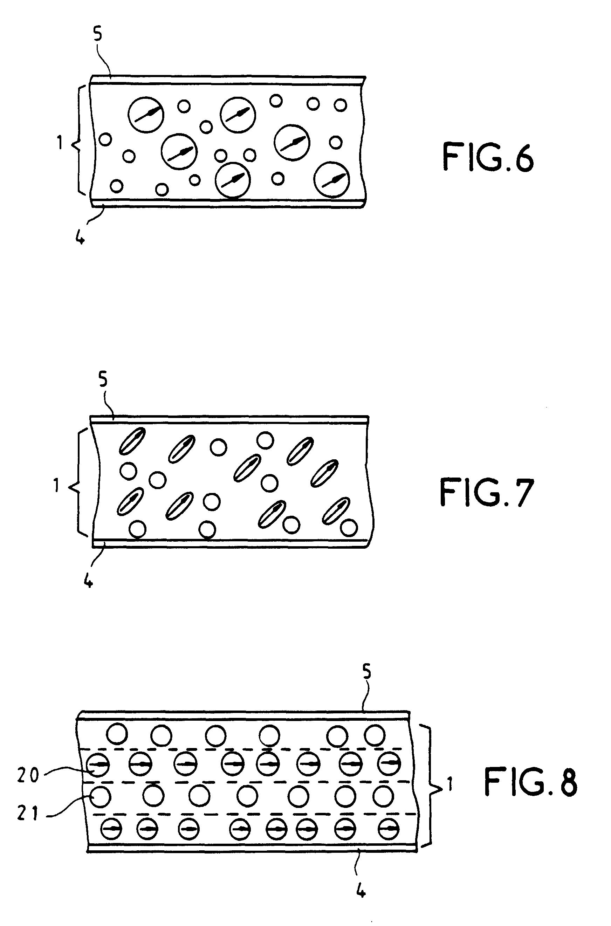

Dans les exemples de réalisation des figures 1 à 5, en champ nul, les aimantations des grains en matériau magnétique sont orientées de façon aléatoire. Dans le cas des figures 6 à 8, certains grains sont orientés. On a donc une différence de résistivité importante entre le cas où on applique un champ orienté selon le même sens que l'aimantation des grains et le cas où on applique un champ orienté dans le sens contraire de l'aimantation des grains.

De plus, avec les grains aimantés on a donc une réponse qui est sensible à l'orientation du champ magnétique. Mais dans ce cas là on a une plus grande sensibilité.

Les types de particules peuvent être différents également en raison des tailles différentes des particules. En particulier, on peut prévoir d'avoir des particules de deux tailles différentes. La couche 1 étant soumise à un champ magnétique intense, l'aimantation des particules les plus grosses s'aligne irréversiblement selon ce champ. On doit alors considérer que la taille des particules influence leur réponse en champ au sens que le temps de relaxation dépend exponentiellement du volume des particules.

Selon l'invention, comme cela est représenté sur la figure 6, les grosses particules ont leur aimantation dirigée dans une direction définie ; par exemple après application d'un champ qui les aura saturés selon celle-ci. Ceci permet de retrouver une modulation relative de résistivité égale à $\Delta$ et non plus $\Delta/2$, et une résistance fonction impaire du champ appliqué.

Selon une variante de réalisation, les types de particules diffèrent par leurs formes comme cela est représenté en figure 7. Notamment, selon un mode préféré de réalisation, on prévoit deux types de forme de particules dont certaines sont plus allongées que les autres.

Les particules les plus éloignées de la sphéricité ont leur aimantation qui tend à être figée. En effet, le facteur de forme des particules influence leur réponse en champ au sens que le temps de relaxation dépend exponentiellement de leur constante d'anisotropie.

Sur la figure 7, on voit que par exemple par dépôt sous champ magnétique, les particules non sphériques ont un de leur axe principal d'élongation dirigé dans une direction définie. Ceci permet de retrouver une modulation relative de résistivité égale à $\Delta$ et non plus $\Delta/2$, et une résistance fonction impaire du champ appliqué.

Dans ce qui précède, la répartition des différentes particules n'a pas été précisée et on peut considérer que cette disposition est aléatoire.

Cependant, selon l'invention on peut prévoir d'arranger les particules dans la couche 1 selon une répartition déterminée. Notamment, selon la figure 8, on prévoit des couches alternées de particules de types différents.

Par exemple, en prévoyant des particules 20 dont l'aimantation est fixée et est insensible au champ à détecter et des particules 21 dont l'aimantation est sensible au champ à détecter, on dispose différentes couches dont certaines comportent des particules 20 et d'autres des particules 21. En prévoyant des couches suffisamment minces on peut obtenir un dispositif dans lequel, selon la direction perpendiculaire aux plans des couches, une particule 21 n'a comme premières particules voisines, des particules 20 et réciproquement. De cette façon, les jonctions tunnels entre particules de même type ne percolent pas à travers le matériau.

Le transducteur magnétorésistif selon l'invention présente les avantages suivants qui découlent de la conception de la couche de matériau particulaire.

- une résistivité :

$$\rho \approx \left( \left[ \frac{G_0}{d} e^{-\frac{<d>}{\lambda}} \right]^{-1} \right) \tag{4}$$

ajustable car l'on peut contrôler l'espacement moyen $<d>$ entre particules lors du dépôt par exemple par le choix de la fraction volumique de métal, ce qui permet d'atteindre des valeurs de l'ordre de 100 $\Omega.cm^{13}$ autorisant une mise en oeuvre en transport perpendiculaire et rendant inutile des géométries de type serpentin en transport parallèle.

- un comportement magnétique anhystérétique et dépourvu de bruit de type Barkausen pour des champs variables de fréquence inférieure à:

$$v_{max} = \frac{1}{\tau} = \frac{1}{\tau_0} e^{-\frac{E_b}{kT}} \tag{5}$$

Cette fréquence peut atteindre des valeurs de l'ordre de 100 MHz pour des particules d'une dizaine de nanomètres de diamètre si l'on choisit des matériaux à très faible anisotropie, comme l'alliage (Fe,Ni) au voisinage de la composition $Ni_{80}Fe_{20}$. La mise en oeuvre dans des capteurs à temps de réponse nécessairement court, tel que des têtes de lecture dans des systèmes d'enregistrement à haut débit, est donc envisageable.

- une perméabilité magnétique dont une valeur typique devrait se situer aux alentours de 400, sachant qu'une assemblée de particules de $Ni_{80}Fe_{20}$ de 10 nm de diamètre devrait saturer vers 10 Oe (conformément à une loi de Langevin) avec une aimantation à saturation de 10 000 G, et qu'une fraction volumique de 40 % pour le matériau magnétique semble tout à fait compatible avec une conduction dominée par l'effet tunnel entre particules isolées. Ceci devrait permettre un couplage efficace du transducteur à un éventuel circuit magnétique, tel que dans une tête de lecture pour l'enregistrement magnétique.

- par conséquent, une magnétorésistance en champ faible, puisqu'en champ nul la distribution d'orientation relative d'aimantations entre particules voisines est uniforme, alors qu'en régime de saturation (c'est-à-dire pour un champ appliqué supérieur ou égal au 10 Oe précédemment cités) toutes les aimantations sont alignées avec le champ extérieur, donc parallèles entre elles. La modélisation théorique montre que l'on obtient dans ces conditions une modulation relative de résistivité égale à $\Delta/2$. Cette grandeur est au plus de l'ordre de 7 % dans les systèmes déjà expérimentés, mais compte tenu de sa grande sensibilité aux détails de la structure électronique de la jonction des valeurs beaucoup plus élevées ne sont pas à exclure.

- une magnétorésistance et une résistivité quasi indépendantes de la température. En effet pour des particules d'un diamètre voisin de 100 nm le phénomène de blocage de Coulomb devient négligeable, et l'effet tunnel pratiquement indépendant de la température.

- comme pour les multicouches métalliques magnétiques, une magnétorésistance indépendante de l'orientation du courant relativement aux aimantations.

La réalisation d'un dispositif tel que représenté en figure 1 peut se faire par sputtering tel qu'un substrat qui est fixé sur un support tournant qui passe successivement devant plusieurs sources. Par exemple une source contenant un des matériaux magnétiques et l'isolant, et une deuxième source contenant le second matériau magnétique et le même isolant. Ou bien deux cibles contenant les mêmes matériaux mais en concentrations différentes pour l'obtention de grains de tailles différentes.

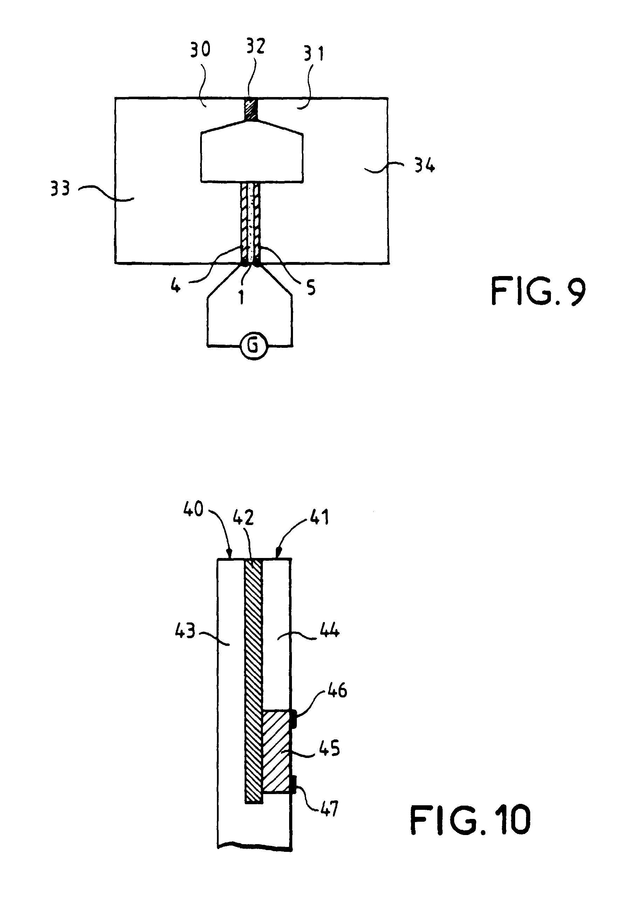

La figure 9 représente une application du transducteur magnétorésistif à la réalisation d'une tête magnétique de lecture.

Cette tête de lecture comporte deux pôles magnétiques 30,31 séparés par un entrefer 32. Les pôles 30,31 sont reliés par un circuit magnétique 33,34 dans lequel est inséré, en série, un transducteur selon l'invention. Ce transducteur comporte donc une couche en matériau composite enserré entre deux électrodes 4 et 5.

Un support d'enregistrement portant des informations magnétiques lorsqu'il passe devant l'entrefer 32 induit un champ magnétique qui se referme dans le circuit magnétique 33,34. Le transducteur 1,4,5 est donc soumis à ce champ et un appareil de mesure de résistance G mesure une variation de résistance.

La figure 10 représente un exemple de réalisation d'une tête magnétique en couches minces comprenant deux couches 43, 44 en matériau magnétique séparées par une couche 42 en matériau non magnétique.

Les extrémités 40, 41 des couches 43, 44 constituent les pôles magnétiques de la tête et sont séparées par la couche d'entrefer 42. L'une des couches 44 par exemple est interrompue et comprend, dans l'interruption, une couche 45 selon l'invention. La couche 45 est munie d'électrodes 46, 47 permettant de mesurer la résistivité de cette couche.

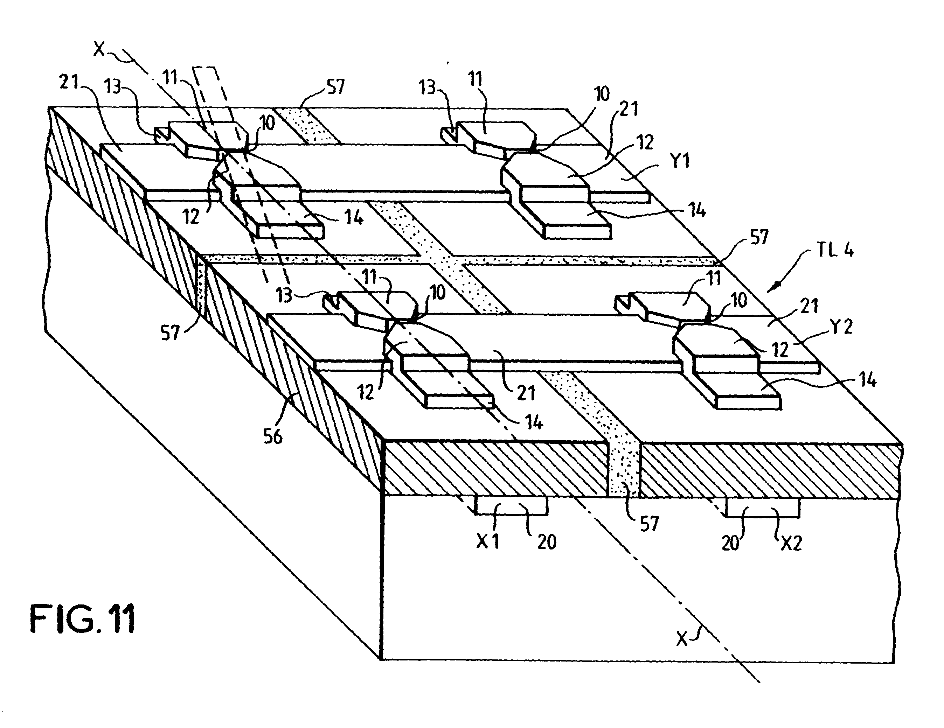

La figure 11 représente une tête magnétique planaire comportant un arrangement matriciel de têtes magnétiques élémentaires.

Chaque tête magnétique élémentaire comporte deux pôles magnétiques 11, 12 séparés par un entrefer 10. L'ensemble est porté par au moins une couche 56 en matériau selon l'invention, c'est-à-dire comportant des particules en matériau magnétique noyées dans un matériau non magnétique. Des électrodes X1, Y2 placées de chaque côté de la couche 56 permettent de mesurer sa résistivité. Dans l'arrangement matriciel de la figure 11, une électrode Y2 est placée entre la couche 56 et les pôles d'une rangée de l'autre côté de la couche 56, sous une colonne de pôles orthogonalement à l'électrode Y2.

Dans ce qui précède on a considéré que les particules sensibles au champ magnétique à détecter sont superparamagnétiques mais on peut aussi considérer qu'elles sont à champ coercitif très faible.

Dans ce cas, le désordre d'orientation des aimantations en champ faible n'est plus assuré par les fluctuations thermiques, mais par la répartition isotrope des axes "faciles" desdites particules douces.

A titre d'exemple, les particules de matériau magnétique peuvent être des particules en alliages de Ni, Co, Fe tels que $Ni_{1-x}$, $Fe_x$, $Ni_{1-x-y}$, $Fe_xCo_y$ ou pour les matériaux magnétiques "durs". La matrice c'est-à-dire le matériau englobant ces particules peut être en $SiO_2$, $Al_2O_3$, C, Si, Ge, AsGa, ...

**Revendications**

1.  Tête de lecture magnétique caractérisée en ce qu'elle comporte :

    -   une couche (56) d'un matériau composite comportant des particules de matériau magnétique (2) noyées dans un matériau non magnétique (3) et isolant ou semiconducteur;
    -   deux pôles magnétiques (11, 12) séparés par un entrefer (10) et situés sur une première face de la couche (56) de matériau composite ;
    -   un premier conducteur (Y1) situé sur la première face de la couche (56) de matériau composite entre cette face et les deux pôles magnétiques (11, 12);
    -   un deuxième conducteur (X1) situé sur une deuxième face de la couche (56) de matériau composite opposée à la première face.

2.  Tête de lecture selon la revendication 1, caractérisée en ce qu'elle comporte un arrangement matriciel de têtes magnétiques, le premier conducteur (Y1) étant situé sous les pôles magnétiques (11, 12) d'une rangée et le deuxième conducteur (X1) étant situé sous une colonne de pôles magnétiques (11, 12) orthogonalement au premier conducteur (Y1).

3.  Tête de lecture magnétique selon la revendication 1, caractérisée en ce que les particules de matériau magnétique (2) sont superparamagnétiques.

4.  Tête de lecture magnétique selon la revendication 1, caractérisée en ce que les particules de matériau magnétique (2) possèdent un champ coercitif très faible.

5.  Tête de lecture magnétique selon la revendication 1, caractérisée en ce qu'elle comporte des moyens (6) pour appliquer un champ magnétique permanent de polarisation.

6. Tête de lecture magnétique selon la revendication 5, caractérisée en ce qu'elle comporte un aimant permanent (7).

7. Tête de lecture magnétique selon la revendication 6, caractérisée en ce que l'aimant permanent est constitué par une couche mince d'un matériau magnétique.

8. Tête de lecture magnétique selon la revendication 6, caractérisée en ce que l'aimant permanent comporte une boucle conductrice (7) parcourue par un courant continu.

9. Tête de lecture magnétique selon la revendication 1, caractérisée en ce que les particules sont toutes d'un même matériau.

10. Tête de lecture magnétique selon la revendication 1, caractérisée en ce que les particules sont réparties de façon uniforme.

11. Tête de lecture magnétique selon la revendication 1, caractérisée en ce qu'elle comporte au moins deux types de particules :

   - des particules d'un premier type en matériau insensible au champ à détecter ;
   - des particules d'un deuxième type en matériau dont l'aimantation s'aligne avec le champ à détecter.

12. Tête de lecture magnétique selon la revendication 11, caractérisée en ce que les particules du premier type et du second type sont réparties de telle façon qu'en moyenne elles soient alternées.

13. Tête de lecture magnétique selon la revendication 12, caractérisé een ce que les particules sont réparties de façon à avoir des couches alternées de particules du premier type et du second type parallèles aux électrodes.

14. Tête de lecture magnétique selon la revendication 11, caractérisée en ce que les particules du premier type ont leur magnétisation permanente dirigée parallèlement à une direction définie.

15. Tête de lecture magnétique selon la revendication 11, caractérisée en ce que les particules du premier type sont de dimensions supérieures à celles des particules du deuxième type.

16. Tête de lecture magnétique selon la revendication 11, caractérisée en ce que les particules du premier type sont non sphériques tandis que les particules du deuxième type ont une forme sensiblement sphérique.


**Patentansprüche**

1. Magnetlesekopf, dadurch gekennzeichnet, daß er

   - eine Schicht (56) aus einem Verbundwerkstoff, der Partikel (2) aus magnetischem Material enthält, die in ein unmagnetisches Material, ein Isolatormaterial oder ein Halbleitermaterial (3) eingelassen sind;
   - zwei Magnetpole (11, 12), die durch einen Spalt (10) getrennt sind und auf einer ersten Seite der Schicht (56) aus Verbundwerkstoff angeordnet sind;
   - einen ersten Leiter (Y1), der auf der ersten Seite der Schicht (56) aus Verbundwerkstoff zwischen der Seite und den zwei Magnetpolen (11, 12) angeordnet ist; und
   - einen zweiten Leiter (X1), der auf einer zweiten, der ersten Seite gegenüberliegenden Seite der Schicht (56) aus Verbundwerkstoff angeordnet ist, umfaßt.

2. Lesekopf nach Anspruch 1, dadurch gekennzeichnet, daß er eine Matrixanordnung aus Magnetköpfen umfaßt, bei der der erste Leiter (Y1) unter den Magnetpolen (11, 12) einer Zeile angeordnet ist und der zweite Leiter (X1) unter einer Spalte der Magnetpole (11, 12) senkrecht zum ersten Leiter (Y1) angeordnet ist.

3. Magnetlesekopf nach Anspruch 1, dadurch gekennzeichnet, daß die Partikel (2) aus magnetischem Material superparamagnetisch sind.

**4.** Magnetlesekopf nach Anspruch 1, dadurch gekennzeichnet, daß die Partikel (2) aus magnetischem Material ein schwaches Koerzitivfeld besitzen.

**5.** Magnetlesekopf nach Anspruch 1, dadurch gekennzeichnet, daß er Mittel (6) umfaßt, die dazu dienen, ein permanentes Polarisationsmagnetfeld anzulegen.

**6.** Magnetlesekopf nach Anspruch 5, dadurch gekennzeichnet, daß er einen Permanentmagneten (7) umfaßt.

**7.** Magnetlesekopf nach Anspruch 6, dadurch gekennzeichnet, daß der Permanentmagnet aus einer dünnen Schicht magnetischen Materials besteht.

**8.** Magnetlesekopf nach Anspruch 6, dadurch gekennzeichnet, daß der Permanentmagnet eine leitfähige Windung (7) umfaßt, durch die ein kontinuierlicher Strom fließt.

**9.** Magnetlesekopf nach Anspruch 1, dadurch gekennzeichnet, da die Teilchen alle aus demselben Material bestehen.

**10.** Magnetlesekopf nach Anspruch 1, dadurch gekennzeichnet, daß die Teilchen gleichmäßig verteilt sind.

**11.** Magnetlesekopf nach Anspruch 1, dadurch gekennzeichnet, daß er zwei Arten von Teilchen enthält:

- Teilchen einer ersten Art, die aus einem Material sind, das gegenüber dem zu erfassenden Feld unempfindlich sind;
- Teilchen einer zweiten Art, die aus einem Material sind, dessen Magnetisierung sich zu dem zu erfassenden Feld ausrichtet.

**12.** Magnetlesekopf nach Anspruch 11, dadurch gekennzeichnet, daß die Teilchen der ersten Art und die Teilchen der zweiten Art so verteilt sind, daß sie sich im Mittel abwechseln.

**13.** Magnetlesekopf nach Anspruch 12, dadurch gekennzeichnet, daß die Teilchen so verteilt sind, daß abwechsend eine Schicht aus Teilchen der ersten Art und eine Schicht aus Teilchen der zweiten Art auftritt, wobei die Schichten parallel zu den Elektroden liegen.

**14.** Magnetlesekopf nach Anspruch 11, dadurch gekennzeichnet, daß die permanente Magnetisierung der Teilchen der ersten Art parallel zu einer definierten Richtung ausgerichtet ist.

**15.** Magnetlesekopf nach Anspruch 11, dadurch gekennzeichnet, daß die Teilchen der ersten Art größer als die Teilchen der zweiten Art sind.

**16.** Magnetlesekopf nach Anspruch 11, dadurch gekennzeichnet, daß die Teilchen der ersten Art nicht kugelförmig sind, während die Teilchen der zweiten Art eine im wesentlichen kugelförmige Form aufweisen.

**Claims**

**1.** Magnetic read head, characterized in that it includes:

- a layer (56) of a composite material including particles of magnetic material (2) which are embedded in a nonmagnetic and insulating or semiconducting material (3);
- two magnetic poles (11, 12) which are separated by an airgap (10) and are located on a first face of the layer (56) of composite material;
- the first conductor (Y1) located on the first face of the layer (56) of composite material between this face and the two magnetic poles (11, 12);
- a second conductor (X1) located on a second face of the layer (56) of composite material on the opposite side from the first face.

**2.** Read head according to Claim 1, characterized in that it includes a matrix arrangement of magnet heads, the first conductor (Y1) being located under the magnetic poles (11, 12) in a row and the second conductor (X1) being located under a column of magnet poles (11, 12) orthogonally to the first conductor (Y1).

3. Magnetic read head according to Claim 1, characterized in that the particles of magnetic material (2) are super paramagnetic.

4. Magnetic read head according to Claim 1, characterized in that the particles of magnetic material (2) have a very weak coercive force.

5. Magnetic read head according to Claim 1, characterized in that it includes means (6) for applying a permanent polarizing magnetic field.

6. Magnetic read head according to Claim 5, characterized in that it includes a permanent magnet (7).

7. Magnetic read head according to Claim 6, characterized in that the permanent magnet consists of a thin film of a magnetic material.

8. Magnetic read head according to Claim 6, characterized in that the permanent magnet includes a conducting loop (7) through which a direct current flows.

9. Magnetic read head according to Claim 1, characterized in that the particles are all made of the same material.

10. Magnetic read head according to Claim 1, characterized in that the particles are distributed uniformly.

11. Magnetic read head according to Claim 1, characterized in that it includes at least two types of particles:

   - particles of a first type, made of a material insensitive to the field to be detected;
   - particles of a second type, made of a material whose magnetization aligns with the field to be detected.

12. Magnetic read head according to Claim 11, characterized in that the particles of the first type and of the second type are distributed so that on average they alternate.

13. Magnetic read head according to Claim 12, characterized in that the particles are distributed so as to have alternate layers of particles of the first type and of the second type which are parallel to the electrodes.

14. Magnetic read head according to Claim 11, characterized in that the particles of the first type have their permanent magnetization directed parallel to a defined direction.

15. Magnetic read head according to Claim 11, characterized in that the particles of the first type have dimensions larger than those of the particles of the second type.

16. Magnetic read head according to Claim 11, characterized in that the particles of the first type are non-spherical whereas the particles of the second type have a substantially spherical shape.

FIG.1a

FIG.1b

ISOLANT

FIG. 2

FIG.3

10

FIG.4

FIG.5

FIG.6

FIG.7

FIG.8

FIG. 9

FIG. 10

FIG.11